(19) Europäisches Patentamt
European Patent Office
Office européen des brevets

(11) **EP 4 213 342 B1**

(12) **EUROPEAN PATENT SPECIFICATION**

(45) Date of publication and mention
of the grant of the patent:
**29.07.2026 Bulletin 2026/31**

(21) Application number: **23156327.1**

(22) Date of filing: **27.11.2019**

(51) International Patent Classification (IPC):
*H02J 50/60* (2016.01)    *H02J 50/12* (2016.01)

(52) Cooperative Patent Classification (CPC):
**H02J 50/60; H02J 50/12**

(54) **ENHANCED FOREIGN OBJECT DETECTION WITH COIL CURRENT SENSING IN WIRELESS POWER TRANSFER SYSTEMS**

VERBESSERTE FREMDKÖRPERDETEKTION MIT SPULENSTROMMESSUNG IN DRAHTLOSEN STROMÜBERTRAGUNGSSYSTEMEN

DÉTECTION AMÉLIORÉE D'OBJETS ÉTRANGERS AVEC DÉTECTION DE COURANT DE BOBINE DANS DES SYSTÈMES DE TRANSFERT D'ÉNERGIE SANS FIL

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **28.11.2018 US 201862772592 P
21.03.2019 US 201962821899 P
03.05.2019 US 201916403419
27.09.2019 US 201916586212**

(43) Date of publication of application:
**19.07.2023 Bulletin 2023/29**

(62) Document number(s) of the earlier application(s) in accordance with Art. 76 EPC:
**19211875.0 / 3 661 014**

(73) Proprietor: **Integrated Device Technology, Inc.
San Jose CA 95138 (US)**

(72) Inventors:
• **MEHAS, Gustavo James
WA 98040 Mercer Island (IS)**
• **BAVISI, Amit D.
Los Gatos 95032 (US)**
• **SMITH, Nicholaus Wayne
La Mesa 91942 (US)**

(74) Representative: **Lippert Stachow Patentanwälte Rechtsanwälte
Partnerschaft mbB
Königsbrücker Straße 124
01099 Dresden (DE)**

(56) References cited:
**US-A1- 2015 333 797     US-A1- 2017 063 165**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

Embodiments of the present invention are related wireless power transfer and more particularly to enhanced foreign object detection with coil current sensing in wireless power transfer systems.

According to some embodiments, Wireless power transfer (WPT), wireless power transmission, wireless energy transmission (WET), or electromagnetic power transfer is the transmission of electrical energy without wires as a physical link. In a wireless power transmission system, a transmitter device, driven by electric power from a power source, generates a time-varying electromagnetic or magnetic field, which transmits power across space to a receiver device, which extracts power from the field and supplies it to an electrical load. Wireless power transfer is useful to power electrical devices where interconnecting wires are inconvenient, hazardous, or are not possible. The transmitter circuit is usually built on an integrated circuit (IC) chip. Traditionally, due to limitations on the charging power, circuit area and foreign object detection capacity of the transmitter IC chip, a wireless power transmitter that includes one transmitter IC chip can only be used to charge one wireless power receiving device at a time. Thus, multiple wireless chargers are usually used if more than one wireless devices are to be charged at the same time. The cost of obtaining a number of wireless chargers can be significant.

In addition, foreign object detection (FOD) is continuously a problem for such systems. A foreign object can appear at any time during the transfer of wireless power between the transmitter and the receiver. The presence of a foreign object not only affects the efficiency of the wireless power transfer, but also the foreign object can be subject to excessive heating that can become dangerous. In particular, users usually want to charge their phones faster and over larger X-Y placement areas on a charging panel with a high power level. At high power levels more sensitive foreign object detection (FOD) schemes are needed, as the foreign objects may be limited to certain power absorption (typically around 500 mW), regardless whether the receiver is using 1 W or a much higher power level. So at higher power levels, the signal-to-noise ratio (SNR) may decline, and thus a more sensitive FOD scheme is needed.

Therefore, there is a need to develop a way of providing high power wireless power transfer for multiple wireless devices with an accurate and efficient FOD mechanism.

Prior art is disclosed in US 2015/333797 A1 and US 2017/063165 A1.

In view of the FOD issues in high-power charging with multiple wireless devices, embodiments described herein provide a method for foreign object detection based on coil current sensing at a wireless power transmitting device. Specifically, the method includes determining, via a coil current sensing circuit at the wireless power transmitting device, a coil current value corresponding to a first coil current that passes through a first transmitter coil. The method further comprises computing, via a controller at the wireless power transmitting device, a transmitter power loss based on the coil current value. The method further comprises determining, during wireless power transfer from the wireless power transmitting device to a wireless power receiving device, an existence of a foreign object in vicinity of the first transmitter coil when a change in the computed transmitter power loss meets a threshold condition.

Embodiments described herein further provide a wireless power transmitting device for foreign object detection based on coil current sensing. The wireless power transmitting device includes a transmitter coil, a coil current sensing circuit coupled to the transmitter coil, and a controller. The controller is configured to determine, via the coil current sensing circuit, a coil current value corresponding to a first coil current that passes through a first transmitter coil, compute a transmitter power loss based on the coil current value, and determine, during wireless power transfer from the wireless power transmitting device to a wireless power receiving device, an existence of a foreign object in vicinity of the first transmitter coil when a change in the computed transmitter power loss meets a threshold condition.

These and other embodiments are discussed below with respect to the following figures.

Figure 1 illustrates an example wireless power transmission system that is configured to engage coil current sensing for a multi-coil transmitter, according to some embodiments.

Figure 2A provides an example diagrams illustrating the impact of a foreign object on the power loss of the wireless power transfer system shown in Figure 1, according to an embodiment.

Figure 2B provides example diagrams illustrating the impact of friendly metal heating vs. receiver position on power loss calculations, according to an embodiment.

Figure 2C provides an example diagram illustrating the impact of the distance in the Z direction on the transmitter coil current, according to an embodiment.

Figure 3 provide an example schematic circuit diagram for a coil current sensing circuit, according to embodiments described herein.

Figure 4A provides an example schematic circuit diagram for an auto-selection circuit that selects a coil to monitor in a multi-coil transmitter, according to embodiments described herein.

Figures 4B provides an example schematic circuit diagram further illustrating a selection circuit that selects a coil for current sensing via MOSFET sampling in a multi-coil transmitter, and Figure 4C provides example waveforms according to embodiments described herein

Figure 5 provides an example schematic circuit diagram showing a multi-coil transmitter similar to that in Figure 4 but with a diode method for ADC measurement, according to embodiments described herein.

Figure 6A provides an example data plot showing a curve fitting equation to calculate transmitter coil RMS current based on the peak detector voltage to ADC.

Figure 6B provides an example schematic circuit diagram illustrating a circuit implementation of converting a sensed coil current to a coil current RMS value.

Figure 7A provides an example logic flow diagram illustrating an example process for using coil current sensing to detect foreign objects, according to embodiments described herein.

Figure 7B provides an example logic flow diagram illustrating operating the circuit shown in Figure 6B to convert a sensed coil current to a coil current RMS value.

FIG. 7C provides a simplified logic flow diagram illustrating an example process 750 for computing the RMS value based on the operating frequency of the system, according to embodiments described herein.

Figures 8A-8B provides example diagrams illustrating increased the X-Y active area of the charging plane of a wireless power transmitter, according to an embodiment described herein.

Figures 9A-9B illustrates the fast charging current profile and an example charging window for the fast charging, respectively.

Figures 10B-10D provide different examples of multi-coil transmitters for multi-device charging.

These and other aspects of embodiments of the present invention are further discussed below.

In the following description, specific details are set forth describing some embodiments of the present invention. It will be apparent, however, to one skilled in the art that some embodiments may be practiced without some or all of these specific details. The specific embodiments disclosed herein are meant to be illustrative but not limiting. One skilled in the art may realize other elements that, although not specifically described here, are within the scope of the claims.

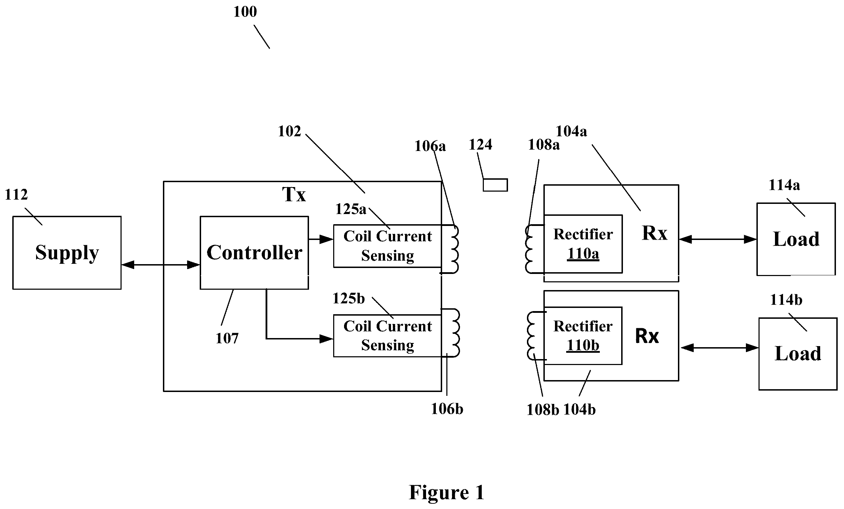

This description illustrates inventive aspects and embodiments should not be taken as limiting the claims define the protected invention. Various changes may be made without departing from the scope of the claims. In some instances, well-known structures and techniques have not been shown or described in detail in order not to obscure the invention. Figure 1 illustrates an example wireless power transmission system 100 that is configured to engage coil current sensing for a multi-coil transmitter, according to some embodiments. As illustrated in Figure 1, a power transmitter TX 102 is coupled to a power supply 112 that provides power to drive TX 102. The controller 107 of Tx 102 is configured to generate an alternate current (AC) through the one or more transmitter coils 106a, 106b, each of which produces a time varying magnetic field. Each of the time varying magnetic fields produced by the transmitter coils 106a and 106b (herein collectively referred to as transmitter coil 106) induces a respective current in receiver coil 108a and 108b, respectively. Receiver coil 108a or 108b (herein collectively referred to as receiver coil 108) is coupled to a respective power receiver RX 104a or 104b (herein collectively referred to as receiver 104), respectively, each of which receives the transmitted wireless power. A rectifier circuit 110a or 110b (herein collectively referred to as rectifier 110) is within the receiving device 104a or 104b, respectively, configured to receive and rectifies wireless power received at the receiver coil 108a or 108b, and then in turn provides an output voltage for battery charging.

Thus, each of the receiver RX 104a and 104b is coupled to a load 114a or 114b, for example, a battery charger, which is configured to charge a battery with the received power. In this way, the load 114a and 114b can be charged with wireless power transferred from Tx 102 at the same time. Or alternatively, with the multiple transmitter coils 106a and 106b, the transmitting device 102 may have a larger active charging area and a receiving device can be placed with more freedom on the charging area to be charged.

In one embodiment, the Tx controller 107 can be built on a single IC chip. For the Tx 102 to charge more than one device at once, the controller 107 is configured to provide high power transfer of up to at least 20 W, authentication for safe high power wireless transfer. In addition, as more than one receiving device 104a and 104b are placed in vicinity to Tx 102, the controller 107 is configured to provide foreign object detection (FOD) via coil current sensing and increased X-Y placement ability for multiple receiving devices.

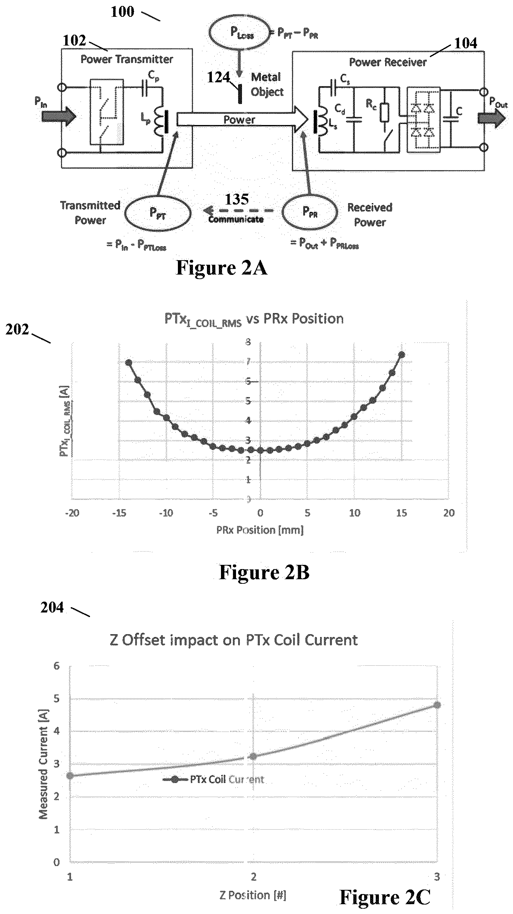

As is further illustrated in Figure 1, when a foreign object 124 is placed in vicinity to the transmitter coil 106a-b or receiver coil 108a-b, the foreign object 124 can interfere with the transmission of power between transmitting device 102 and receiving device(s) 104a-b. For example, Figures 2A provide an example diagram illustrating the impact of a foreign object on the power loss of the wireless power transfer system 100 shown in Figure 1, according to an embodiment. In accordance with embodiments, the transmitting device 102 finds the power loss $P_{LOSS}$ when a metal object 124 is placed in vicinity to the transmitter coil during the wireless power transfer, calculated as the difference between the transmitted power $P_{PT}$ from transmitter coil and the received power $P_{PR}$ received at the receiver coil. If $P_{LOSS}$ is big, then a foreign object issue exists.

To calculate the power loss $P_{LOSS}$ during transfer, the transmitting device 102 calculates the input power $P_{IN}$ and the transmitter power loss $P_{PTLoss}$ and the receiving device 104 tells the transmitting device 102 the received power $P_{PR}$, e.g., by sending a received power packet (RPP) 135 to transmitting device 102. Specifically, existing systems under Wireless Power Consortium (WPC) standard usually computes the power $P_{PT}$ output from the transmitting device 102, by:

$$P_{PT} = Vin \text{ (or } VBRG) \times Iin - P_{PTLoss}$$

where Vin, Iin denote the input voltage (VBRG is the Bridge voltage applied to the the Tx DC to AC inverter to create the Tx magnetic field) and input current at transmitting device 102, respectively, and $TX_{LOSSES}$ denotes the power loss within the transmitting device 102, e.g., power consumed at the transmitter coil and electrical components necessary to create the Tx magnetic field. While at the receiving device 114, $P_{PR}$, the power received at the receiving device 104, is calculated by:

$$P_{PR} = Vrect \times Iout + P_{PRLoss}$$

wherein Vrect denotes the voltage at the rectifier circuit 110 at receiving devices 104, Iout denotes the output charging current from the receiving device 104, and $P_{PRLoss}$ denotes the power loss within the receiving device 104. $P_{PR}$ is then communicated to transmitting device 102 via RPP 135. Thus, to employ the conventional WPC calculation for FOD power loss, the average input current Iin and average input voltage Vin are measured, and then $Tx_{LOSSES}$ is calculated, e.g., via extrapolation.

However, extrapolation of transmitter power losses is not as good as direct measurement. Integrated Circuits (ICs) can be designed to directly measure the transmitter coil current. The measured transmitter coil current (RMS or peak current) and phase relative to Tx coil voltage provides an indicator of the transmitter coil losses, which is usually the major source of power loss in the transmitting device 102. Retrofitting this concept of transmitter coil current measurement into existing ICs can be challenging and costly.

Figures 2B-2C provide example data diagrams illustrating impacts of the alignment between the transmitting device 102 and the receiving device 104 on the power loss and coil current, according to some embodiments described herein. The transmitter coil current can vary with the position of the receiver coil 108 (of the receiving device 104). For example, as shown in the data diagrams 202, the transmitter power loss (reflected by the transmitter coil current PTx_coil_IRMS) may vary up to four times while the X-Y position of the receiving device varies, e.g., when the receiving device moves on the X-Y plane of the transmitter charging pad. As shown in data diagram 204, the transmitter coil current may change from 2.6A to close to 5A while the Z-position (e.g., the direction vertical to the charging panel) of the transmitter coil changes relative to the receiver coil.

Embodiments described herein provide a coil current sensing circuit to ICs with analog-to-digital converters (ADCs). The coil sensing circuit 125a-b may be placed internally to the transmitting device 102 to measure the coil current of the coils 106a-b. Or alternatively, the coil sensing circuit 125a-b may be placed external to the IC of transmitting device 102, and is communicatively coupled to the coils 106a-b. Specifically, the coil current sensing circuit is configured to measure a peak coil current value and the resonant frequency at the coil. The controller 107 then calculates a root mean square of the coil current for power loss calculation at transmitter coil 106a-b. In this way, the transmitter power loss computed directly based on the coil current (instead of the conventional computation based on transmitter input current) can provide improved precision of a change in the power loss. Thus, the computed power loss can be used to more accurately detect a foreign object near the transmitter coil during a wireless power transfer. The enhanced precision of power loss computation obviates or reduces the impact of X-Y position of the coils on FOD, and thus provides for enhanced X-Y freedom of charging placement.

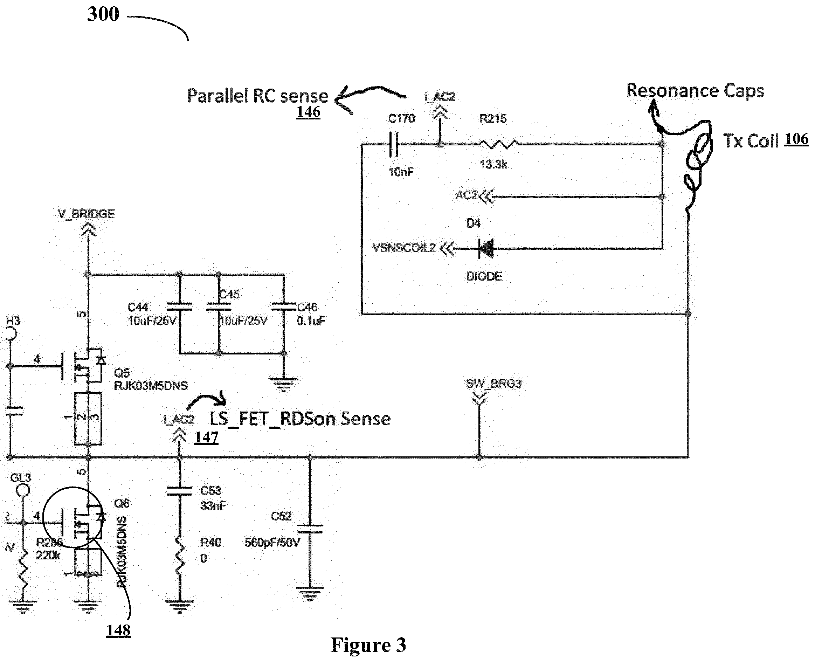

Figure 3 provide an example schematic circuit diagram 300 for a coil current sensing circuit (similar to 125a-b in Figure 1), according to embodiments described herein. In one embodiment, the coil sensing circuit is coupled to transmitter coil 106, which is further coupled to resonance capacitors 144 (not shown). The coil sensing circuit obtains measurements such as an inductor alternate current resistance (ACR), the MOSFET drain-source on resistance (RDSON), i.e., the total resistance between the drain and source of the MOSFET, sensor resistance, and/or the like, and then measure the voltages across the inductor coil, the MOSFET, the sensor, and/or the like to monitor the coil current that passes through the Tx coil 106.

In one embodiment, inductor current sensing for the transmitter coil 106 may be conducted based on inductor current sensing: $L/ACR = R \times C$ such that the voltage across the equivalent lumped element alternate current resistor (ACR) of the transmitter coil 106 is equal to the voltage across the capacitor component of the parallel resistor-capacitor (RC) filter. L denotes the inductance of the coil 106, R denotes the resistance of resistor (e.g., see R215) in the parallel RC circuit, and C denotes the capacitance of the capacitor (e.g., see C170) in the parallel RC circuit. Thus, the voltage (at node 146) across the capacitor C170 in the parallel resistor- RC circuit consisting of capacitor C170 and resistor R215 is sampled. The measured voltage at node 146 of the RC circuit is indicative of the coil current that passes through Tx coil 106.

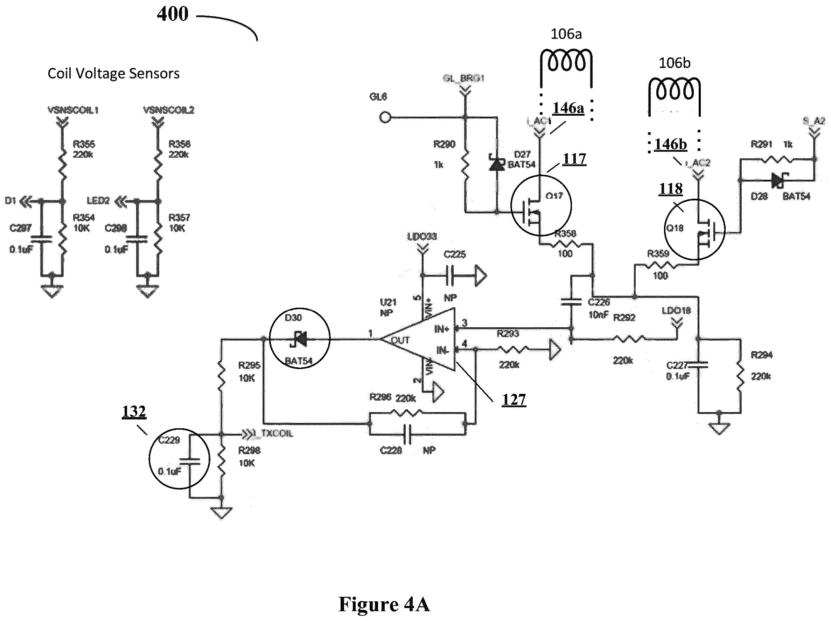

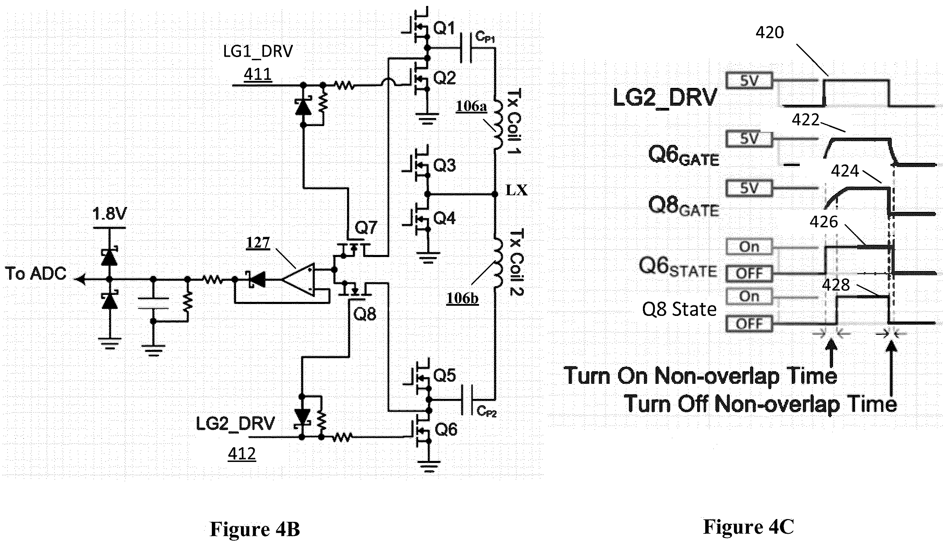

In one embodiment, the low side MOSFET RDSON can be measured, or a sensing resistor (which may add additional component cost and power loss) can be used to measure the coil current, e.g., by measuring the voltage (at node 147) across the low-side MOSFET Q6 (as shown at circle 148 in diagram 300) divided by the MOSFET RDSON, or the voltage across the sensing resistor divided by the sensing resistance. An OPAMP (shown at 127 in Figure 4) may be used help these measurements as such measurements can be 4 times lower than the ACR sensing.

Figure 4A provides an example schematic circuit diagram 400 for an auto-selection circuit that selects a coil to monitor in a multi-coil transmitter, according to embodiments described herein. When the transmitter has more than one coils, e.g., transmitter coils 106a-b shown in Figure 1, MOSFETs 117 and 118 are used to control which coil is to be measured. For example, the MOSFETs 117 and 118 are each coupled to transmitter coils 106a or 106b, respectively, and are each tied to a dedicated gate signal that turns the MOSFET 117 or 118 on or off to automatically select which coil is being monitored. Thus, MOSFET 117 or 118 only becomes an active path when the respective gate signal is positive, and the respective coil 106a or 106b is energized. When the MOSFET 117 or 118 is active, the voltage at node i_AC1 or i_AC2 is measured, respectively, to indicate the current of the respective coil coupled to MOSFET 117 or 118, e.g., by dividing the MOSFET RDSON of MOSFET 117 or 118.

In some embodiments, a parallel RC circuit (e.g., similar to c170 and R215 shown in Figure 3) is placed in parallel to the transmitters coil 106a or 106b such that the MOFSET 117 or 118 may sample the voltage at node 146a or 146b via parallel RC sensing. The sampled voltage of the parallel RC circuit is indicative of the coil current that passes through Tx coil 106a or 106b, respectively.

For illustrative purpose, diagram 400 shows two coils 106a-b and two MOSFETs 117-118 for automatically selecting the coil to be measured. Multiple coils (e.g., more than two) can be used in the transmitter. Each transmitter coil (e.g., more than two) is coupled to a sampling MOSFET with a current sensing circuit for the respective coil such that the sampling MOSFET may be used to sample a voltage in the current sensing circuit, which is indicative of the coil current that passes through the respective transmitter coil.

Diagram 400 further includes an OPAMP 127 to amplify the signal from coil 106a or 106b before feeding to an analog-to-digital converter (ADC) that converts the analog current or voltage to a digital measurement to the processor (e.g., controller 107 in Figure 1). In this way, the OPAMP 127 provides improved signal-to-noise ratio (SNR) and additional buffering of the signal.

Diagram 400 further shows a diode D30 at 131 coupled to the output of the OPAMP 127, which may serve as part of a peak detector to detect the peak voltage. In some examples, diode D30 charges the capacitor C229 (at 132) to the peak of the input voltage to diode D30 in a positive "half cycle" when the input voltage at diode D30 is higher than the voltage at C229. When the input voltage at diode D30 falls below the "peak" voltage stored on the capacitor C229, the diode D30 is reverse biased, blocking current flow from capacitor C229 back to the input end of diode D30. The capacitor C229 retains the peak voltage value even as the input voltage to diode D30 drops to zero. Thus, the peak coil current ICOIL_Peak can be measured by measuring the peak voltage retained by diode D30 and capacitor C229.

The resonant frequency F_Resonant is also measured (e.g., via Q measurement techniques) to convert the peak current ICOIL_PEAK to the root-mean square of the coil current ICOIL_RMS. ICOIL_RMS is then used to calculate the coil power loss. For example, the ICOIL_RMS may be computed via the following equation:

$$ICOIL\_RMS = a \times ICOIL\_ADC^2 - b \times ICOIL\_ADC + c$$

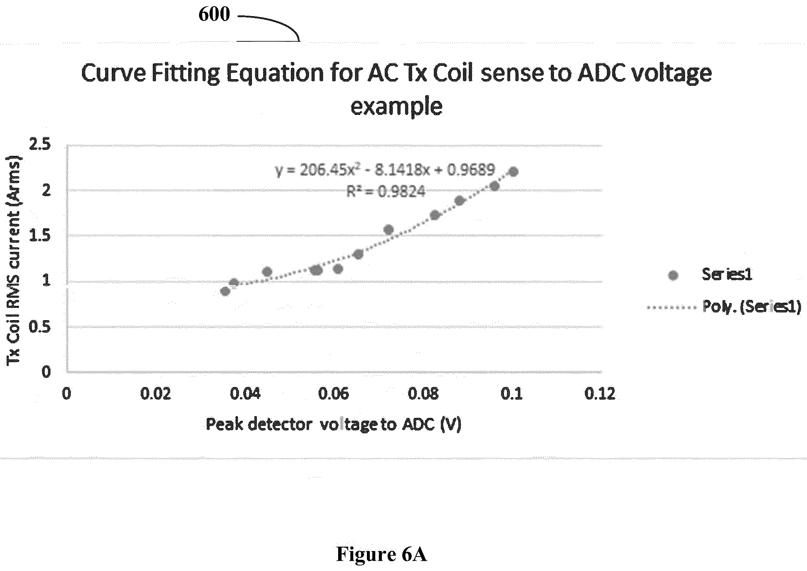

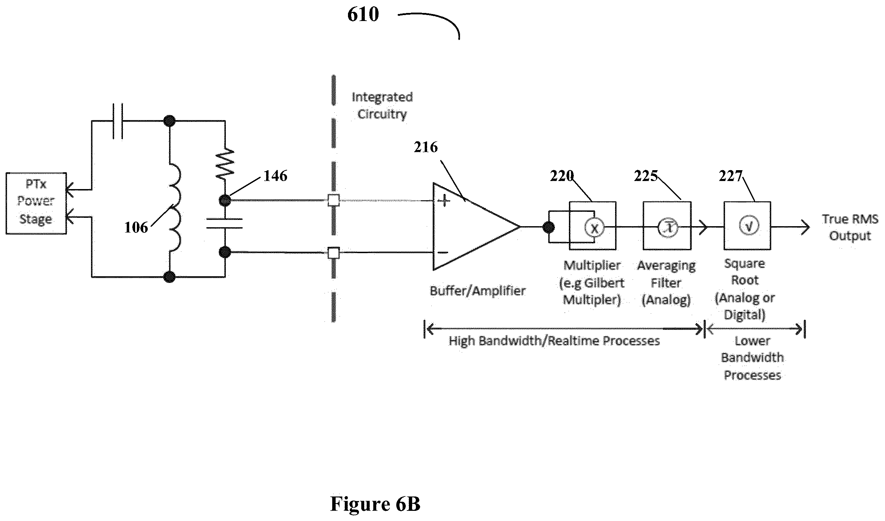

where ICOIL_ADC denotes the peak current fed to the analog-to-digital converter (ADC), and parameters a, b and c can be found by regressing data samples of peak detector voltage to ADC and the transmitter coil RMS current. For example, Figure 6A provides an example data plot 600 showing a curve fitting equation to calculate transmitter coil RMS current based on the peak detector voltage to ADC. In this example, the ICOIL_RMS may be calculated as: $206.45x^2 - 8.1418x + 0.9689$, where x denotes the peak detector voltage to ADC. Alternatively, a circuit 610 as shown in Figure 6B may be used to convert the sensed coil current to a RMS value.

In some embodiments, as the current that passes through the transmitter coil 106 is an alternate current, the peak coil current and (the resulting ICOIL_RMS) may be detected via each half bridge of the switching network. For example, a first peak coil current (and a first ICOIL_RMS is computed accordingly) can be sensed when a first half bridge of the switching network is on, and a second peak coil current can be sensed (and a second ICOIL_RMS is computed accordingly) when the other half bridge of the switching network is on. The RMS of the coil current can then be computed as an average of the first ICOIL_RMS and the second ICOIL_RMS. In some embodiments, when the switching network may not have 50% time on for each half bridge due to the dead time (e.g., the time for the coil current to transit from the lowest negative to the highest positive), a weighted average of the first ICOIL_RMS and the second ICOIL_RMS may be implemented, with the weights reflecting the portion of time that the coil current is at the negative or the positive peak, respectively.

In some embodiments, the deadtime may be adjusted by calibrating the wireless transmitter based on feedback from the receiver circuit, as further described in U.S. Application No. 16/371,887, filed April 1 2019.

Figure 4B provides an example schematic circuit diagram further illustrating a selection circuit that selects a coil for current sensing via MOSFET sampling in a multi-coil transmitter, according to embodiments described herein. Specifically, each transmitter coil 106a or 106b is driven by a unique driver voltage LG1_DRV 411 or LG2_DRV 412. For example, when LG2_DRV 412 is on, the sampling MOSFET resistor Q8 is set. As shown in FIG. 4C, the waveform 426 shows Q6 turns on after LG2_DRV (at waveform 420) turns on, and the gate voltage of Q6 (shown at waveform 422) rises up to 5V after a turn-on non-overlap time. Thus, the sampling MOSFET Q8 is turned on after the turn-on non-overlap time (shown at waveform 428). The turn-on non-overlap time is due to sampling MOSFET gate drive resistor, which makes sure that the sampled node is at Ground. Sampling MOSFET Q8 then turns off before LG2_DRV turns off due to diode shorting of gate drive resistor and power MOSFET gate resistor which slows its turnoff. In this way, the sampling MOSFET Q8 is off before the common LX node starts to fly high, and thus the current signal is cleanly sampled by the sampling MOFSET Q8, avoiding switching noise on the LX node.

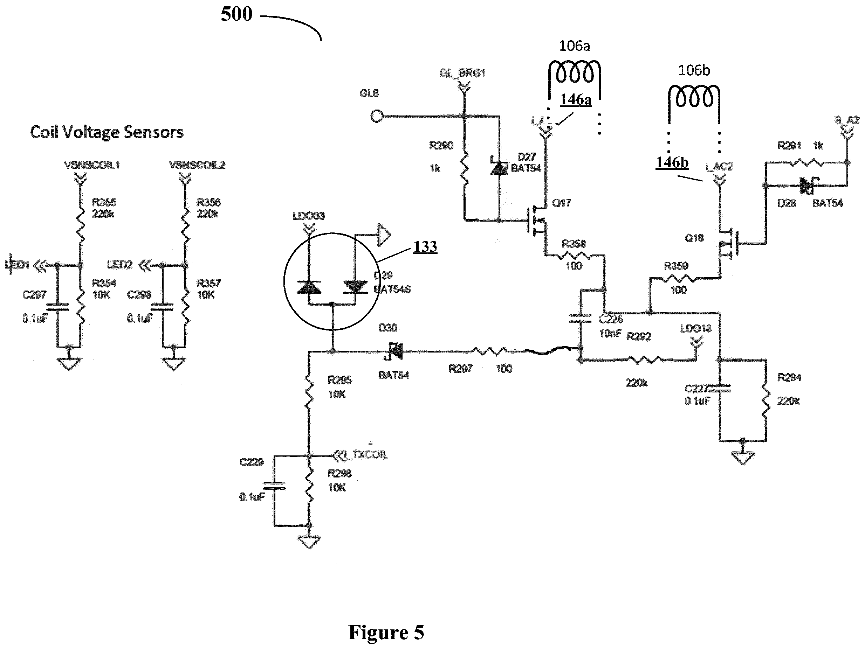

Figure 5 provides an example schematic circuit diagram 500 showing a multi-coil transmitter similar to that in Figure 4 but with a diode method for ADC measurement, according to embodiments described herein. A diode limiter 133 consisting of two diodes connected in parallel in opposite directions is used to regulate the voltage or current signal before the signal is sent to the ADC.

Figure 6A provides an example data plot 600 showing a curve fitting equation to calculate transmitter coil RMS current based on the peak detector voltage to ADC.

Figure 6B provides an example schematic circuit diagram illustrating a circuit implementation of converting a sensed coil current to a coil current RMS value. Specifically, for alternating electric current, the RMS value of the coil current is equal to the value of a direct current that would produce the same average power dissipation at the coil. Therefore, the coil current RMS value is used to compute the coil power loss. The coil current sensed by sampling the voltage level at 146 (e.g., as discussed in relation to Figure 3) is sent to circuitry 610 for converting to the coil current RMS value. Specifically, circuitry 610 includes a buffer or amplifier 216 that is configured to amplify the input voltage signal. The amplified voltage signal is then sent to a multiplier to compute the square value of the amplified voltage signal. For example, the multiplier 220 may be a Gilbert multiplier that receives the amplified voltage signal at both its input ends and generates an output signal that is proportional to the product of the two input signals, i.e., the square of the amplified voltage signal. The multiplier output signal is then sent to an average filter 225, which is configured to take a number of samples of the input, e.g., the square of the amplifier voltage signal, at a time and take the average of the input samples to generate an averaging output signal. The generated averaging output signal is then passed to a square root generator 227, which is configured to compute a square root of the averaging output signal. In this way, when a sensed voltage level at 146, representing an instant coil current level (may or may not be the peak coil current level), is constantly fed to the circuit 610, the RMS value of the coil current may be generated at the output of the square root generator 227.

In circuit 610, the amplifier 216, the multiplier 220 and the averaging filter 225 may be analog devices that are configured to handle an analog input signal, e.g., the sampled voltage level signal from 146. In some embodiments, alternate voltage sampling can be provided via any of the current sensing circuits discussed in relation to FIGS. 3-5, such as but not limited to RDSON sensing, resistor sensing, or a current sensing transformer, etc. The square root generator 227 may generate an analog output or quantize the output to be a digital output. Using an analog front end in the circuit 610 reduces the use of expensive ADCs followed with digital filtering. Thus, the circuit 610 may render a lower cost solution. In addition, the analog front end of devices 216, 220 and 225 provide accurate data measurement as the analog devices yields a higher bandwidth. Circuit 610 may remove the need for a processor to derive IRMS from I_Coil_PEAK (and the other state variables).

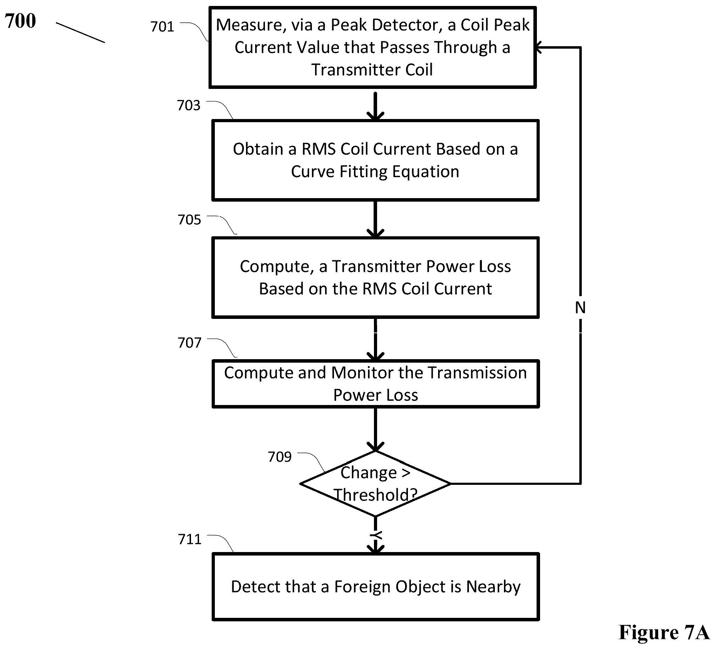

Figure 7A provides a simplified logic flow diagram illustrating an example process 700 for using coil current sensing to detect foreign objects, according to embodiments described herein. At step 701, the coil peak current value that passes through the transmitter coil is measured, via a peak detector (e.g., via peak detector diode 131). The coil current may be sensed by MOSFET sampling the voltage at a parallel RC circuit (e.g., see 146), by measuring MOSFET RDSON, and/or the like, as discussed in relation to Figures 3-5. The measured coil peak current is then fed to the ADC and the controller 107 of the transmitter. At step 703, the controller 107 computes a RMS coil current based on a curve fitting equation, e.g., as shown in Figure 6. At step 705, the transmitter power loss is computed based on the RMS coil current, e.g., $P_{PTLoss} = ICOIL\_RMS^2 \times R_{coil}$. At step 707, the controller 107 is configured to compute and monitor the transmission power loss between the transmitting device and the receiving device. The relationship of the transmitter power loss and the power loss caused by a foreign object near the transmitter coil is described in relation to Figure 2A, e.g., transmission loss $P_{LOSS} = Vin \times Iin - P_{PTLoss} - P_{PR}$, where $P_{PR}$ is obtained via RPP communication 135. At step 709, when the change in the transmission power loss is greater than a threshold, the controller 107 is configured to determine that a foreign object is nearby, at step 711. Otherwise, process 700 goes back to step 701, where the transmitter continues to measure the coil current and monitor power loss change through steps 701-707.

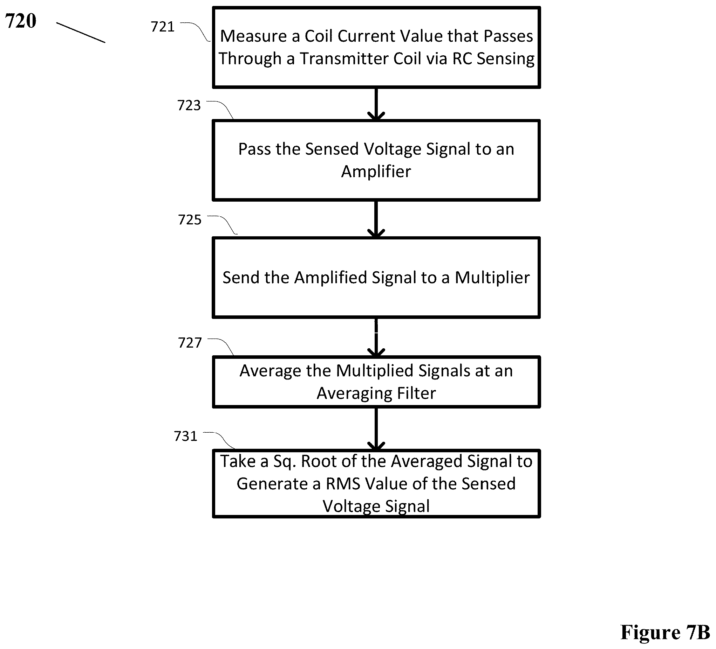

Figure 7B provides an example logic flow diagram illustrating operating the circuit shown in Figure 6B to convert a sensed coil current to a coil current RMS value. Process 720 starts with step 721, at which a coil current value (may or may not contain the peak value) that passes through a transmitter coil is sensed, e.g., by sampling a voltage level via RC sensing, MOFSET RDSON, etc. At step 723, the sensed voltage signal indicative of a coil current level is passed to an amplifier (e.g., analog amplifier 216). At step 725, the amplified signal is sent to a multiplier (e.g., Gilbert multiplier 220) that generates an output signal proportional to the square of the amplified signal. At step 727, the multiplied signal, e.g., the square of the amplified signal, is averaged at the averaging filter (e.g., analog averaging filter 225). At step 731, the square root of the averaged signal is generated (e.g., at square root generator 227), indicative of the RMS value of the coil current.

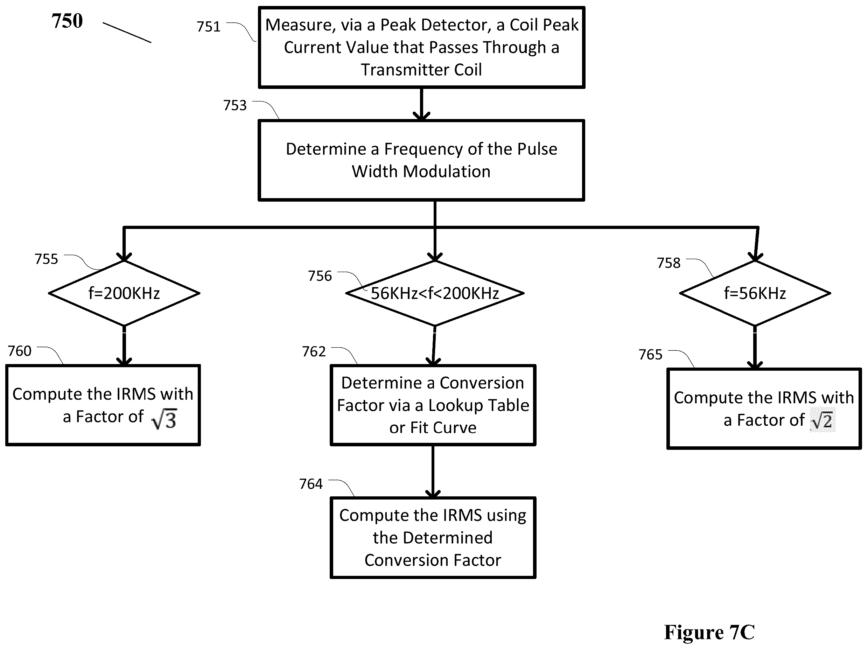

FIG. 7C provides a simplified logic flow diagram illustrating an example process 750 for computing the IRMS based on the operating frequency of the system, according to embodiments described herein. At step 751, a coil peak current value that passes through a transmitter coil is measured, via a peak detector (e.g., via the coil current sensing circuits described in Figs. 3-5). At step 753, the operating frequency of pulse width modulation (PWM) for the system is determined. For example, for a system with a given natural frequency of ~56 kHz (which can be re-measured during operation), an approximate factor may be applied to convert a peak current to IRMS current depending on the operating frequency due to the PWM interrupting the natural wave of the LRC tank. At step 755, if the PWM frequency is 200KHz, a factor of $\sqrt{3}$ is multiplied to the peak coil current to obtain the RMS value. At step 758, if the PWM frequency is 56KHz, a factor of $\sqrt{2}$ is applied. At step 756, if the PWM frequency is between 56KHz and 200 KHz (e.g., at 100KHz), a conversion factor can be determined vai a lookup table, or a fitting curve at step 762. The determined conversion factor is then applied to compute the IRMS from the peak current at step 764. For example, the lookup table stores the peak current, the natural frequency of the system during the measurement window, and the PWM frequency the system is being driven with during the measurement window, and a corresponding conversion factor determined statistically, experimentally or empirically based on the factors. Similarly, a fitting curve may be decided by interpolating empirical data on the PWM frequency of the system and a corresponding conversion factor. In some embodiments, as phones may move, the natural frequency can change during the measurement window. Thus, a long average value for the natural frequency and the PWM operating frequency may be used.

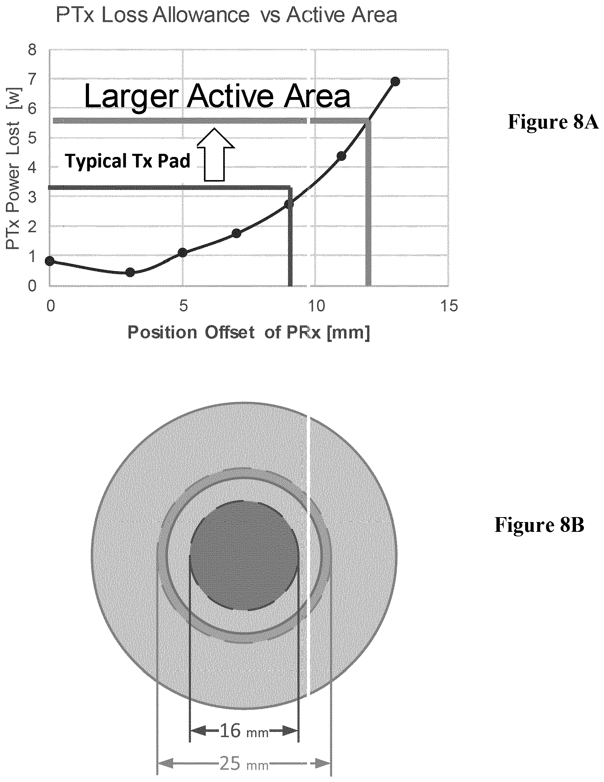

The coil current sensing circuits described in Figures 3-5 provide transmitter power loss calculated with improved precision, which in turn provides the precision of computed transmission power loss. With improved precision in transmission power loss, accuracy of FOD can be improved during the wireless power transfer, increasing the X-Y active area of the charging plane, as indicated in Figures 8A and 8B. The charging area, as indicated in Figure 8A, may be increased by a factor of approximately 2 while the transmitter heating (the transmitter power loss) may increase by about 1.5 times. For example, as shown in Figure 8B, the active area can increase from a diameter of 16mm to 25 mm with enhanced X-Y freedom for FOD.

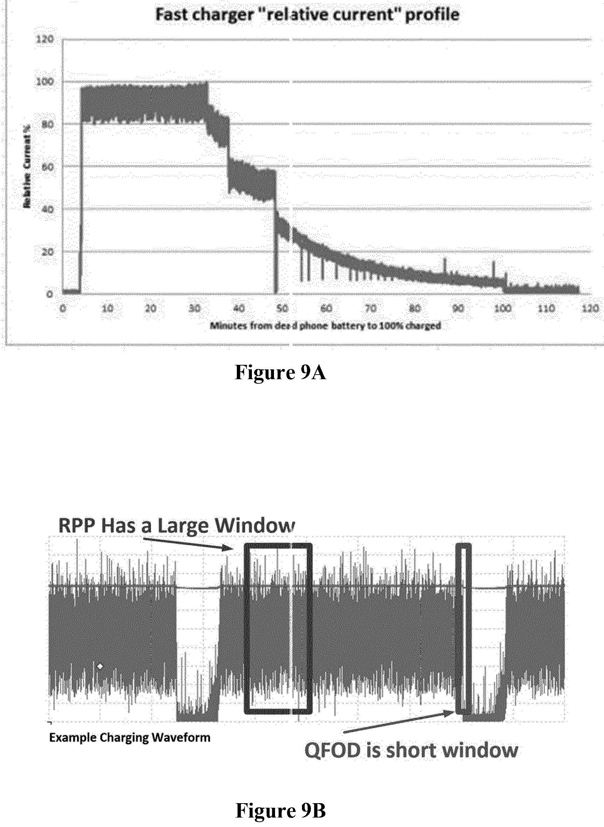

Figure 9A illustrates a fast charger "relative current" profile while Figure 9B illustrates an example charging window. Wireless power charging is noisy due to AP loading, device use during phone charging, and thermal throttling adds to the noise profile. The FOD using coil current sensing described herein uses a long window for low noise. In particular, a number of measurements are averaged together, which improves SNR greatly with no impact on power transfer.

In Q-factor FOD (QFOD), the Q-factor of the circuit may be measured and stored, e.g., in time domain as a decay rate of transmitter coil self-resonance, or in frequency domain as a ratio of the peak frequency to the system bandwidth. The measured Q-factor value may be compared with a reference Q-factor value received from the receiving device to determine whether a foreign object is detected. However, a short measurement window is usually used in QFOD, which results in high noise. The short measurement window yields only a few data points (e.g., 10-12 data points), which is highly susceptible to noise. Low SNR adds error to results. Further, running QFOD may often disrupt power transfer, e.g., for Q-factor measurement. Consequently, the FOD using coil current sensing described herein may yield greater performance than using QFOD.

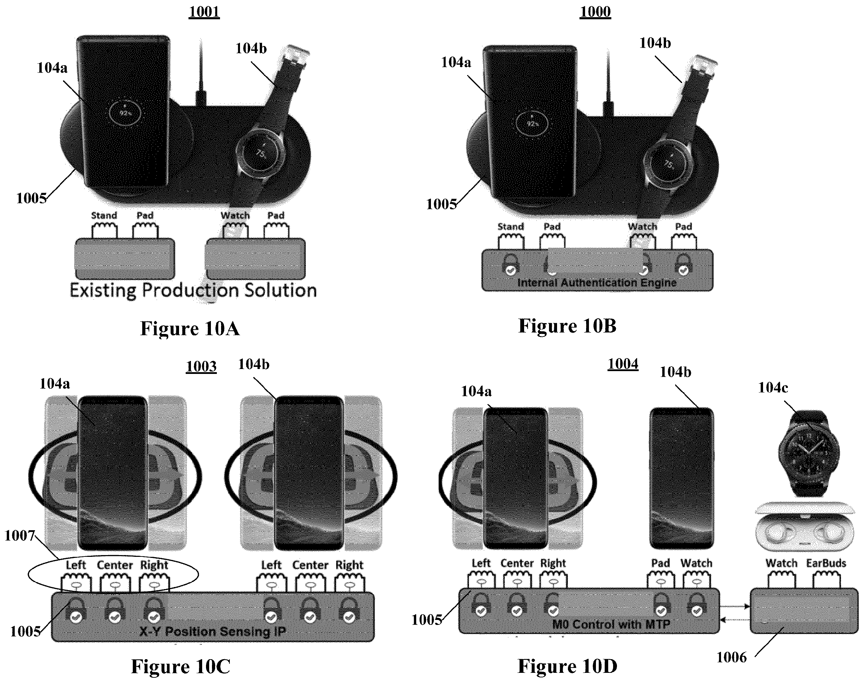

Figures 10B-10D provide different examples of multi-coil transmitters for multi-device charging. Each wireless power charger 1005 can be similar to the wireless transmitter 102 in Figure 1. As shown at diagram 1002 in Figure 10B, the wireless charger 1005 is configured to provide power transfer to two devices 104a and 104b. Specifically, a single Tx controller chip may be configured to drive multiple coils to transfer power to multiple devices 104a and 104b. As shown at diagram 1003 in Figure 10C, the wireless charger 1005 may be equipped with multiple coils 1007 placed at different positions and/or orientations for each charging area. The wireless charger 1005 also includes X-Y position sensors to identify a position of the device 104a or 104b placed at the charging area to as to transfer wireless power. In this way, wireless charger 1005 provides spatial freedom to the devices 104a or 104b and is able to charge a variety of different types of devices. As shown at diagram 1004, the wireless charger 1005 may be equipped with a hybrid of different charging plates, e.g., a charging plate with X-Y position sensors, or a charging plate designed for a specific shape of a device such as a pad or a watch, etc. The different charging plates can be driven by a single Tx controller chip. Diagram 1004 further illustrates an embodiment in which another wireless charger 1006 may be connected to wireless charger 1005, via a wired connection or wirelessly, such that an authentication link may be established between the charger 1005 and 1006 through which the charging device(s) 104a-b may authenticate the charging device 104c.

The wireless charger 1005 may include the coil sensing circuits shown in Figures 3-5, and adopts the coil sensing method discussed in Figure 7. In this way, the wireless charger 1005 computes a transmitter power loss based on coil current with enhanced precision for FOD during the wireless power transfer. In addition, the wireless charger 1005, . for example, as shown at diagrams 1003, 1004, the larger charging plate of the wireless charger 1005 contains multiple coils (e.g., 3, etc.), which allows greater X-Y position freedom such that the charging device 104a may be placed at different positions (e.g., 3 different positions according to the 3 coils in charger 1005) for charging.

The above detailed description is provided to illustrate specific embodiments of the present invention and is not intended to be limiting. Numerous variations and modifications within the scope of the present invention are possible. The present invention is set forth in the following claims.

## Claims

1. A method for foreign object (124) detection based on coil current sensing at a wireless power transmitting device (102), comprising:

    measuring, via a peak detector at a coil current sensing circuit (125a, 125b), a coil peak current value corresponding to a first coil current that passes through a first transmitter coil (106a, 106b);
    determining, via the coil current sensing circuit (125a, 125b) at the wireless power transmitting device (102), a root mean square (RMS) coil current value based on the coil peak current value according to a polynomial relationship between the RMS coil current value and the coil peak current value, wherein the polynomial relationship computes the RMS coil current value as a polynomial function of the coil peak current value, wherein parameters of the polynomial relationship have been determined by regressing data samples;
    computing, via a controller (112) at the wireless power transmitting device (102), a transmitter power loss based on the RMS coil current value; and
    determining, during wireless power transfer from the wireless power transmitting device (102) to a wireless power receiving device (104), an existence of a foreign object (124) in vicinity of the first transmitter coil (106a, 106b) when a change in the computed transmitter power loss meets a threshold condition.

2. The method of claim 1, wherein the polynomial relationship between the room mean square value of the first coil current and the measured coil peak current value is obtained by polynomial regression based on previously obtained data samples of root mean square values of a coil current and peak values of the coil current.

3. The method of claim 1, wherein the measuring, via the peak detector at the coil current sensing circuit (125a, 125b), the coil peak current value that passes through the first transmitter coil (106a, 106b) comprises:

    measuring a voltage across the first transmitter coil (106a, 106b); and
    determining the coil peak current value by dividing the measured voltage by an inductor alternate current resistance of the first transmitter coil (106a, 106b).

4. The method of claim 1, wherein the measuring, via the peak detector at the coil current sensing circuit (125a, 125b), the coil peak current value that passes through the first transmitter coil (106a, 106b) comprises:

    measuring a voltage across a MOSFET (148) in a switching circuit at the wireless power transmitting device (102); and
    determining the coil peak current value by dividing the measured voltage by a resistance between a drain and a source of the MOSFET (148).

5. The method of claim 1, wherein the measuring, via the peak detector at the coil current sensing circuit (125a, 125b), the coil peak current value that passes through the first transmitter coil (106a, 106b) comprises:

    measuring a voltage across a sensing resistor coupled to the first transmitter coil (106a, 106b); and
    determining the coil peak current value by dividing the measured voltage by a resistance of the sensing resistor.

6. The method of claim 1, wherein the measuring, via the peak detector at the coil current sensing circuit (125a, 125b), the coil peak current value that passes through the first transmitter coil (106a, 106b) comprises:

    amplifying, via an operational amplifier at the coil current sensing circuit (125a, 125b), a signal indicative of coil current level;
measuring, via the peak detector, the amplified signal that has an increased signal-noise-ratio; and
sending, to an analog-to-digital converter, the amplified signal.

7. The method of claim 1, wherein the measuring, via the peak detector at the coil current sensing circuit (125a, 125b), the coil peak current value that passes through the first transmitter coil (106a, 106b) comprises:
maintaining a voltage to be measured by the peak detector by using a direct current block capacitor at the coil current sensing circuit (125a, 125b).

8. The method of claim 1, wherein the wireless power transmitting device (102) includes the first transmitter coil (106a, 106b) and a second transmitter coil, and the method further comprising:
selecting, via a selection circuit (117, 118), to monitor a coil current of the first transmitter coil (106a, 106b) or the second transmitter coil depending on whether the first transmitter coil (106a, 106b) or the second transmitter coil is energized.

9. The method of claim 8, further comprising:

configuring a first gate signal to activate a first transistor coupled to the first transmitter coil (106a, 106b) to pass through the coil current when the first transmitter coil (106a, 106b) is energized; and
measuring a voltage across a drain and a source of the first transistor.

10. A wireless power transmitting device (102) for foreign object (124) detection based on coil current sensing, comprising:

a first transmitter coil (106a, 106b);
a coil current sensing circuit (125a, 125b) coupled to the first transmitter coil (106a, 106b);
a peak detector configured to detect a peak coil peak current value corresponding to a first transmitter current that passes through the first transmitter coil (106a, 106b); and
a controller (112) configured to:

determine, via the coil current sensing circuit (125a, 125b) at the wireless power transmitting device (102), a root mean square (RMS) coil current value based on the coil peak current value according to a polynomial relationship between the RMS coil current value and the coil peak current value, wherein the polynomial relationship computes the RMS coil current value as a polynomial function of the coil peak current value, wherein parameters of the polynomial relationship have been determined by regressing data samples;
compute a transmitter power loss based on the RMS coil current value;
determine, during wireless power transfer from the wireless power transmitting device (102) to a wireless power receiving device (104), an existence of a foreign object (124) in vicinity of the first transmitter coil (106a, 106b) when a change in the computed transmitter power loss meets a threshold condition.

11. The device of claim 10, wherein the curve relationship between the room mean square value of the first coil current and the measured coil peak current value is obtained by polynomial regression based on previously obtained data samples of root mean square values of a coil current and peak values of the coil current.

12. The device of claim 10, wherein the coil sensing circuit is further configured to:

measure a voltage across the first transmitter coil (106a, 106b); and
wherein the controller (112) is further configured to determine the coil peak current value by dividing the measured voltage by an inductor alternate current resistance of the first transmitter coil (106a, 106b).

13. The device of claim 10, wherein the coil sensing circuit is further configured to measure a voltage across a MOSFET (148) in a switching circuit at the wireless power transmitting device (102); and wherein the controller (112) is further configured to determine the coil peak current value by dividing the measured voltage by a resistance between a drain and a source of the MOSFET (148).

14. The device of claim 10, wherein the coil current sensing circuit (125a, 125b) is configured to measure a voltage across a sensing resistor coupled to the first transmitter coil (106a, 106b); and wherein the controller (112) is further configured to determine the coil peak current value by dividing the measured voltage by a resistance of the sensing resistor.

15. The device of claim 10, further comprising:

an operational amplifier configured to amplify a signal indicative of coil current level;
wherein the peak detector is configured to detect the amplified signal that has an increased signal-noise-ratio, and send, to an analog-to-digital converter, the amplified signal.

16. The device of claim 10, wherein the coil current sensing circuit (125a, 125b) is further configured to:
maintain a voltage to be measured by the peak detector by using a direct current block capacitor at the coil current sensing circuit (125a, 125b).

17. The device of claim 10, further comprising:

a second transmitter coil; and
a selection circuit (117, 118) configured to select to monitor a coil current of the first transmitter coil (106a, 106b) or the second transmitter coil depending on whether the first transmitter coil (106a, 106b) or the second transmitter coil is energized.

18. The device of claim 17, wherein the selection circuit (117, 118) includes a first transistor coupled to the first transmitter coil (106a, 106b) and a second transistor coupled to the second transmitter coil,

configuring a first gate signal to activate a first transistor coupled to the first transmitter coil (106a, 106b) to pass through the coil current when the first transmitter coil (106a, 106b) is energized; and
measuring a voltage across a drain and a source of the first transistor.

19. The device of claim 10, further comprising:
a peak conversion circuit configured to convert the detected coil peak current to a root mean square value of the first coil current.


## Patentansprüche

1. Verfahren für eine Detektion eines Fremdobjekts (124) basierend auf einer Spulenstromerfassung an einer drahtlosen Energiesendevorrichtung (102), umfassend:

Messen, über einen Spitzendetektor an einer Spulenstromerfassungsschaltung (125a, 125b), eines Spulenspitzenstromwerts, der einem ersten Spulenstrom entspricht, der durch eine erste Sendespule (106a, 106b) fließt;
Bestimmen, über die Spulenstromerfassungsschaltung (125a, 125b) an der drahtlosen Energiesendevorrichtung (102), eines Effektivspulenstromwerts (RMS-Spulenstromwerts) basierend auf dem Spulenspitzenstromwert gemäß einer polynomialen Beziehung zwischen dem RMS-Spulenstromwert und dem Spulenspitzenstromwert, wobei die polynomiale Beziehung den RMS-Spulenstromwert als eine polynomiale Funktion des Spulenspitzenstromwerts berechnet, wobei Parameter der polynomialen Beziehung durch Regression von Datenabtastwerten bestimmt wurden;
Berechnen, mittels einer Steuerung (112) an der drahtlosen Energiesendevorrichtung (102), eines Senderleistungsverlusts basierend auf dem RMS-Spulenstromwert; und
Bestimmen, während einer drahtlosen Energieübertragung von der drahtlosen Energiesendevorrichtung (102) zu einer drahtlosen Energieempfangsvorrichtung (104), eines Vorhandenseins eines Fremdobjekts (124) in einer Nähe der ersten Sendespule (106a, 106b), wenn eine Änderung des berechneten Senderleistungsverlusts eine Schwellenwertbedingung erfüllt.

2. Verfahren nach Anspruch 1, wobei die polynomielle Beziehung zwischen dem Effektivwert des ersten Spulenstroms und dem gemessenen Spulenspitzenstromwert durch polynomielle Regression basierend auf zuvor erhaltenen Datenproben von Effektivwerten eines Spulenstroms und Spitzenwerten des Spulenstroms erhalten wird.

3. Verfahren nach Anspruch 1, wobei das Messen, über den Spitzendetektor an der Spulenstromerfassungsschaltung (125a, 125b), des Spulenspitzenstromwerts, der durch die erste Sendespule (106a, 106b) fließt, umfasst:

Messen einer Spannung über die erste Sendespule (106a, 106b) hinweg; und
Bestimmen des Spulenspitzenstromwerts durch Dividieren der gemessenen Spannung durch einen Induktorwechselstromwiderstand der ersten Sendespule (106a, 106b).

4. Verfahren nach Anspruch 1, wobei das Messen, über den Spitzendetektor an der Spulenstromerfassungsschaltung (125a, 125b), des Spulenspitzenstromwerts, der durch die erste Sendespule (106a, 106b) fließt, umfasst:

Messen einer Spannung über einen MOSFET (148) in einem Schaltkreis an der drahtlosen Energiesendevorrichtung (102) hinweg; und
Bestimmen des Spulenspitzenstromwerts durch Dividieren der gemessenen Spannung durch einen Widerstand zwischen einem Drain und einer Source des MOSFETs (148).

5. Verfahren nach Anspruch 1, wobei das Messen, über den Spitzendetektor an der Spulenstromerfassungsschaltung (125a, 125b), des Spulenspitzenstromwerts, der durch die erste Sendespule (106a, 106b) fließt, umfasst:

Messen einer Spannung über einen Messwiderstand hinweg, der mit der ersten Sendespule (106a, 106b) gekoppelt ist; und
Bestimmen des Spulenspitzenstromwerts durch Dividieren der gemessenen Spannung durch einen Widerstand des Messwiderstands.

6. Verfahren nach Anspruch 1, wobei das Messen, über den Spitzendetektor an der Spulenstromerfassungsschaltung (125a, 125b), des Spulenspitzenstromwerts, der durch die erste Sendespule (106a, 106b) fließt, umfasst:

Verstärken, über einen Operationsverstärker an der Spulenstromerfassungsschaltung (125a, 125b), eines Signals, das einen Spulenstrompegel anzeigt;
Messen, über den Spitzendetektor, des verstärkten Signals, das ein erhöhtes Signal-Rausch-Verhältnis aufweist; und
Übermitteln, an einen Analog-Digital-Wandler, des verstärkten Signals.

7. Verfahren nach Anspruch 1, wobei das Messen, über den Spitzendetektor an der Spulenstromerfassungsschaltung (125a, 125b), des Spulenspitzenstromwerts, der durch die erste Sendespule (106a, 106b) fließt, umfasst:
Aufrechterhalten einer Spannung, die durch den Spitzendetektor durch Verwenden eines Gleichstromsperrkondensators an der Spulenstromerfassungsschaltung (125a, 125b) zu messen ist.

8. Verfahren nach Anspruch 1, wobei die drahtlose Energiesendevorrichtung (102) die erste Sendespule (106a, 106b) und eine zweite Sendespule einschließt, und das Verfahren ferner umfassend:
Auswählen, über eine Auswahlschaltung (117, 118), um einen Spulenstrom der ersten Sendespule (106a, 106b) oder der zweiten Sendespule zu überwachen, in Abhängigkeit davon, ob die erste Sendespule (106a, 106b) oder die zweite Sendespule stromführend ist.

9. Verfahren nach Anspruch 8, ferner umfassend:

Konfigurieren eines ersten Gate-Signals, um einen ersten Transistor zu aktivieren, der mit der ersten Sendespule (106a, 106b) gekoppelt ist, um durch den Spulenstrom zu fließen, wenn die erste Sendespule (106a, 106b) stromführend ist; und
Messen einer Spannung über einen Drain und eine Source des ersten Transistors hinweg.

10. Drahtlose Energiesendevorrichtung (102) für die Detektion des Fremdobjekts (124) basierend auf Spulenstromerfassung, umfassend:

eine erste Sendespule (106a, 106b);
eine Spulenstromerfassungsschaltung (125a, 125b), die mit der ersten Sendespule (106a, 106b) gekoppelt ist;
einen Spitzendetektor, der konfiguriert ist, um einen Spulenspitzenstromspitzenwert zu detektieren, der einem ersten Senderstrom entspricht, der durch die erste Sendespule (106a, 106b) fließt; und eine Steuerung (112), die konfiguriert ist zum:
Bestimmen, über die Spulenstromerfassungsschaltung (125a, 125b) an der drahtlosen Energiesendevorrichtung (102), einen Effektivspulenstromwert (RMS-Spulenstromwert) basierend auf dem Spulenspitzenstromwert gemäß einer polynomialen Beziehung zwischen dem RMS-Spulenstromwert und dem Spulenspitzenstromwert, wobei die polynomiale Beziehung den RMS-Spulenstromwert als eine polynomiale Funktion des Spulenspitzenstromwerts berechnet, wobei Parameter der polynomialen Beziehung durch Regression von Datenabtastwerten bestimmt wurden;

Berechnen eines Senderleistungsverlusts basierend auf dem RMS-Spulenstromwert;

Bestimmen, während der drahtlosen Leistungsübertragung von der drahtlosen Leistungssendevorrichtung (102) zu einer drahtlosen Leistungsempfangsvorrichtung (104), eines Vorhandenseins eines Fremdobjekts (124) in der Nähe der ersten Sendespule (106a, 106b), wenn eine Änderung des berechneten Sendeleistungsverlusts eine Schwellenwertbedingung erfüllt.

**11.** Vorrichtung nach Anspruch 10, wobei die Kurvenbeziehung zwischen dem Effektivwert des ersten Spulenstroms und dem gemessenen Spulenspitzenstromwert durch Polynomregression basierend auf zuvor erhaltenen Datenabtastwerten von Effektivwerten eines Spulenstroms und Spitzenwerten des Spulenstroms erhalten wird.

**12.** Vorrichtung nach Anspruch 10, wobei die Spulenerfassungsschaltung ferner konfiguriert ist zum:

Messen einer Spannung über die erste Sendespule (106a, 106b) hinweg; und
wobei die Steuerung (112) ferner konfiguriert ist, um den Spulenspitzenstromwert durch Dividieren der gemessenen Spannung durch einen Induktorwechselstromwiderstand der ersten Sendespule (106a, 106b) zu bestimmen.

**13.** Vorrichtung nach Anspruch 10, wobei die Spulenerfassungsschaltung ferner konfiguriert ist, um eine Spannung über einen MOSFET (148) in einem Schaltkreis an der drahtlosen Energiesendevorrichtung (102) hinweg zu messen; und wobei die Steuerung (112) ferner konfiguriert ist, um den Spulenspitzenstromwert durch Dividieren der gemessenen Spannung durch einen Widerstand zwischen einem Drain und einer Source des MOSFET (148) zu bestimmen.

**14.** Vorrichtung nach Anspruch 10, wobei die Spulenstromerfassungsschaltung (125a, 125b) konfiguriert ist, um eine Spannung über einen Messwiderstand hinweg zu messen, der mit der ersten Sendespule (106a, 106b) gekoppelt ist; und wobei die Steuerung (112) ferner konfiguriert ist, um den Spulenspitzenstromwert durch Dividieren der gemessenen Spannung durch einen Widerstand des Messwiderstands zu bestimmen.

**15.** Vorrichtung nach Anspruch 10, ferner umfassend:

ein Operationsverstärker, der konfiguriert ist, um ein Signal zu verstärken, das einen Spulenstrompegel anzeigt;
wobei der Spitzendetektor konfiguriert ist, um das verstärkte Signal zu detektieren, das ein erhöhtes Signal-Rausch-Verhältnis aufweist, und das verstärkte Signal an einen Analog-Digital-Wandler zu übermitteln.

**16.** Vorrichtung nach Anspruch 10, wobei die Spulenstromerfassungsschaltung (125a, 125b) ferner konfiguriert ist zum: Aufrechterhalten einer Spannung, die durch den Spitzendetektor durch Verwenden eines Gleichstromsperrkondensators an der Spulenstromerfassungsschaltung (125a, 125b) zu messen ist.

**17.** Vorrichtung nach Anspruch 10, ferner umfassend:

eine zweite Sendespule; und
eine Auswahlschaltung (117, 118), die konfiguriert ist, um auszuwählen, um einen Spulenstrom der ersten Sendespule (106a, 106b) oder der zweiten Sendespule zu überwachen, in Abhängigkeit davon, ob die erste Sendespule (106a, 106b) oder die zweite Sendespule stromführend ist.

**18.** Vorrichtung nach Anspruch 17, wobei die Auswahlschaltung (117, 118) einen ersten Transistor, der mit der ersten Sendespule (106a, 106b) gekoppelt ist, und einen zweiten Transistor einschließt, der mit der zweiten Sendespule gekoppelt ist,

Konfigurieren eines ersten Gate-Signals, um einen ersten Transistor zu aktivieren, der mit der ersten Sendespule (106a, 106b) gekoppelt ist, um durch den Spulenstrom zu fließen, wenn die erste Sendespule (106a, 106b) stromführend ist; und
Messen einer Spannung über einen Drain und eine Source des ersten Transistors hinweg.

**19.** Vorrichtung nach Anspruch 10, ferner umfassend:
eine Spitzenumwandlungsschaltung, die konfiguriert ist, um den detektierten Spulenspitzenstrom in einen Effektivwert des ersten Spulenstroms umzuwandeln.

**Revendications**

**1.** Procédé de détection d'objet étranger (124) basé sur une détection de courant de bobine au niveau d'un dispositif de transmission d'énergie sans fil (102), comprenant :

la mesure, par l'intermédiaire d'un détecteur de crête au niveau d'un circuit de détection de courant de bobine (125a, 125b), d'une valeur de courant de crête de bobine correspondant à un premier courant de bobine qui passe à travers une première bobine émettrice (106a, 106b) ;
la détermination, par l'intermédiaire du circuit de détection de courant de bobine (125a, 125b) au niveau du dispositif de transmission d'énergie sans fil (102), d'une valeur de courant de bobine moyenne quadratique (RMS) sur la base de la valeur de courant de crête de bobine selon une relation polynomiale entre la valeur de courant de bobine RMS et la valeur de courant de crête de bobine, dans lequel la relation polynomiale calcule la valeur de courant de bobine RMS en tant que fonction polynomiale de la valeur de courant de crête de bobine, dans lequel des paramètres de la relation polynomiale ont été déterminés en régressant des échantillons de données ;
le calcul, par l'intermédiaire d'un dispositif de commande (112) au niveau du dispositif de transmission d'énergie sans fil (102), d'une perte d'énergie d'émetteur sur la base de la valeur de courant de bobine RMS ; et
la détermination, pendant le transfert d'énergie sans fil du dispositif de transmission d'énergie sans fil (102) à un dispositif de réception d'énergie sans fil (104), de l'existence d'un objet étranger (124) à proximité de la première bobine d'émission (106a, 106b) lorsqu'un changement dans la perte d'énergie d'émetteur calculée satisfait à une condition seuil.

**2.** Procédé selon la revendication 1, dans lequel la relation polynomiale entre la valeur quadratique moyenne de la pièce du premier courant de bobine et la valeur de courant de crête de bobine mesurée est obtenue par régression polynomiale sur la base d'échantillons de données obtenus précédemment de valeurs quadratiques moyennes d'un courant de bobine et de valeurs de crête du courant de bobine.

**3.** Procédé selon la revendication 1, dans lequel la mesure, par l'intermédiaire du détecteur de crête au niveau du circuit de détection de courant de bobine (125a, 125b), de la valeur de courant de crête de bobine qui traverse la première bobine émettrice (106a, 106b) comprend :

la mesure d'une tension à travers la première bobine émettrice (106a, 106b) ; et
la détermination de la valeur de courant de crête de bobine en divisant la tension mesurée par une résistance de courant alternatif d'inducteur de la première bobine émettrice (106a, 106b).

**4.** Procédé selon la revendication 1, dans lequel la mesure, par l'intermédiaire du détecteur de crête au niveau du circuit de détection de courant de bobine (125a, 125b), de la valeur de courant de crête de bobine qui traverse la première bobine émettrice (106a, 106b) comprend :

la mesure d'une tension aux bornes d'un MOSFET (148) dans un circuit de commutation au niveau du dispositif de transmission d'énergie sans fil (102) ; et
la détermination de la valeur de courant de crête de bobine en divisant la tension mesurée par une résistance entre un drain et une source du MOSFET (148).

**5.** Procédé selon la revendication 1, dans lequel la mesure, par l'intermédiaire du détecteur de crête au niveau du circuit de détection de courant de bobine (125a, 125b), de la valeur de courant de crête de bobine qui traverse la première bobine émettrice (106a, 106b) comprend :

la mesure d'une tension à travers une résistance de détection couplée à la première bobine émettrice (106a, 106b) ; et
la détermination de la valeur de courant de crête de bobine en divisant la tension mesurée par une résistance de la résistance de détection.

**6.** Procédé selon la revendication 1, dans lequel la mesure, par l'intermédiaire du détecteur de crête au niveau du circuit de détection de courant de bobine (125a, 125b), de la valeur de courant de crête de bobine qui traverse la première bobine émettrice (106a, 106b) comprend :

l'amplification, par l'intermédiaire d'un amplificateur opérationnel au niveau du circuit de détection de courant de bobine (125a, 125b), d'un signal indiquant le niveau de courant de bobine ;

la mesure, par l'intermédiaire du détecteur de pic, du signal amplifié qui a un rapport signal-bruit augmenté ; et

l'envoi, à un convertisseur d'analogique à numérique, du signal amplifié.

7. Procédé selon la revendication 1, dans lequel la mesure, par l'intermédiaire du détecteur de crête au niveau du circuit de détection de courant de bobine (125a, 125b), de la valeur de courant de crête de bobine qui traverse la première bobine émettrice (106a, 106b) comprend :

le maintien d'une tension à mesurer par le détecteur de crête à l'aide d'un condensateur bloc de courant continu au niveau du circuit de détection de courant de bobine (125a, 125b).

8. Procédé selon la revendication 1, dans lequel le dispositif de transmission d'énergie sans fil (102) comporte la première bobine émettrice (106a, 106b) et une seconde bobine émettrice, et le procédé comprenant en outre :

la sélection, par l'intermédiaire d'un circuit de sélection (117, 118), du fait de surveiller un courant de bobine de la première bobine émettrice (106a, 106b) ou de la seconde bobine émettrice selon que la première bobine émettrice (106a, 106b) ou la seconde bobine émettrice est excitée.

9. Procédé selon la revendication 8, comprenant en outre :

la configuration d'un premier signal de grille pour activer un premier transistor couplé à la première bobine émettrice (106a, 106b) pour passer à travers le courant de bobine lorsque la première bobine émettrice (106a, 106b) est excitée ; et

la mesure d'une tension à travers un drain et une source du premier transistor.

10. Dispositif de transmission d'énergie sans fil (102) pour la détection d'un objet étranger (124) sur la base d'une détection de courant de bobine, comprenant :

une première bobine émettrice (106a, 106b) ;

un circuit de détection de courant de bobine (125a, 125b) couplé à la première bobine émettrice (106a, 106b) ;

un détecteur de crête configuré pour détecter une valeur de courant de crête de bobine correspondant à un premier courant d'émetteur qui passe à travers la première bobine émettrice (106a, 106b) ; et un dispositif de commande (112) configuré pour :

déterminer, par l'intermédiaire du circuit de détection de courant de bobine (125a, 125b) au niveau du dispositif de transmission d'énergie sans fil (102), une valeur de courant de bobine moyenne quadratique (RMS) sur la base de la valeur de courant de crête de bobine selon une relation polynomiale entre la valeur de courant de bobine RMS et la valeur de courant de crête de bobine, dans lequel la relation polynomiale calcule la valeur de courant de bobine RMS en tant que fonction polynomiale de la valeur de courant de crête de bobine, dans lequel des paramètres de la relation polynomiale ont été déterminés en régressant des échantillons de données ;

calculer une perte d'énergie d'émetteur sur la base de la valeur de courant de bobine RMS ;

déterminer, pendant le transfert d'énergie sans fil du dispositif de transmission d'énergie sans fil (102) à un dispositif de réception d'énergie sans fil (104), l'existence d'un objet étranger (124) à proximité de la première bobine émettrice (106a, 106b) lorsqu'un changement dans la perte d'énergie d'émetteur calculée satisfait à une condition seuil.

11. Dispositif selon la revendication 10, dans lequel la relation de courbe entre la valeur quadratique moyenne de la pièce du premier courant de bobine et la valeur de courant de crête de bobine mesurée est obtenue par régression polynomiale sur la base d'échantillons de données obtenus précédemment de valeurs quadratiques moyennes d'un courant de bobine et de valeurs de crête du courant de bobine.

12. Dispositif selon la revendication 10, dans lequel le circuit de détection de bobine est en outre configuré pour :

mesurer une tension aux bornes de la première bobine émettrice (106a, 106b) ; et

dans lequel le dispositif de commande (112) est en outre configuré pour déterminer la valeur de courant de crête de bobine en divisant la tension mesurée par une résistance de courant alternatif d'inducteur de la première bobine émettrice (106a, 106b).

13. Dispositif selon la revendication 10, dans lequel le circuit de détection de bobine est en outre configuré pour mesurer une tension à travers un MOSFET (148) dans un circuit de commutation au niveau du dispositif de transmission d'énergie sans fil (102) ; et dans lequel le dispositif de commande (112) est en outre configuré pour déterminer la valeur de courant de crête de bobine en divisant la tension mesurée par une résistance entre un drain et une source du MOSFET (148).

14. Dispositif selon la revendication 10, dans lequel le circuit de détection de courant de bobine (125a, 125b) est configuré pour mesurer une tension à travers une résistance de détection couplée à la première bobine émettrice (106a, 106b) ; et dans lequel le dispositif de commande (112) est en outre configuré pour déterminer la valeur de courant de crête de bobine en divisant la tension mesurée par une résistance de la résistance de détection.

15. Dispositif selon la revendication 10, comprenant en outre :
un amplificateur opérationnel configuré pour amplifier un signal indiquant le niveau de courant de la bobine ; dans lequel le détecteur de crête est configuré pour détecter le signal amplifié qui a un rapport signal-bruit accru, et envoyer, à un convertisseur d'analogique à numérique, le signal amplifié.

16. Dispositif selon la revendication 10, dans lequel le circuit de détection de courant de bobine (125a, 125b) est en outre configuré pour :
maintenir une tension à mesurer par le détecteur de crête à l'aide d'un condensateur bloc de courant continu au niveau du circuit de détection de courant de bobine (125a, 125b).

17. Dispositif selon la revendication 10, comprenant en outre :

une seconde bobine émettrice ; et
un circuit de sélection (117, 118) configuré pour sélectionner la surveillance d'un courant de bobine de la première bobine émettrice (106a, 106b) ou de la seconde bobine émettrice selon que la première bobine émettrice (106a, 106b) ou la seconde bobine émettrice est excitée.

18. Dispositif selon la revendication 17, dans lequel le circuit de sélection (117, 118) comporte un premier transistor couplé à la première bobine émettrice (106a, 106b) et un second transistor couplé à la seconde bobine émettrice,

la configuration d'un premier signal de grille pour activer un premier transistor couplé à la première bobine émettrice (106a, 106b) pour passer à travers le courant de bobine lorsque la première bobine émettrice (106a, 106b) est excitée ; et
la mesure d'une tension à travers un drain et une source du premier transistor.

19. Dispositif selon la revendication 10, comprenant en outre :
un circuit de conversion de crête configuré pour convertir le courant de crête de bobine détecté en une valeur quadratique moyenne du premier courant de bobine.

Figure 1

**Figure 2A**

**Figure 2B**

**Figure 2C**

**Figure 3**

EP 4 213 342 B1

**Figure 4A**

EP 4 213 342 B1

Figure 4C

Figure 4B

**Figure 5**

EP 4 213 342 B1

EP 4 213 342 B1

**Curve Fitting Equation for AC Tx Coil sense to ADC voltage example**

600

$$y = 206.45x^2 - 8.1418x + 0.9689$$
$$R^2 = 0.9824$$

Series1

········· Poly. (Series1)

**Figure 6A**

**Figure 6B**

**700**

701 — Measure, via a Peak Detector, a Coil Peak Current Value that Passes Through a Transmitter Coil

703 — Obtain a RMS Coil Current Based on a Curve Fitting Equation

705 — Compute, a Transmitter Power Loss Based on the RMS Coil Current

707 — Compute and Monitor the Transmission Power Loss

709 — Change > Threshold?

N

Y

711 — Detect that a Foreign Object is Nearby

**Figure 7A**

**720**

721 — Measure a Coil Current Value that Passes Through a Transmitter Coil via RC Sensing

723 — Pass the Sensed Voltage Signal to an Amplifier

725 — Send the Amplified Signal to a Multiplier

727 — Average the Multiplied Signals at an Averaging Filter

731 — Take a Sq. Root of the Averaged Signal to Generate a RMS Value of the Sensed Voltage Signal

**Figure 7B**

**750**

751 — Measure, via a Peak Detector, a Coil Peak Current Value that Passes Through a Transmitter Coil

753 — Determine a Frequency of the Pulse Width Modulation

755 — f=200KHz

756 — 56KHz<f<200KHz

758 — f=56KHz

760 — Compute the IRMS with a Factor of $\sqrt{3}$

762 — Determine a Conversion Factor via a Lookup Table or Fit Curve

765 — Compute the IRMS with a Factor of $\sqrt{2}$

764 — Compute the IRMS using the Determined Conversion Factor

**Figure 7C**

Figure 8A

Figure 8B

**Figure 9A**

**Figure 9B**

**Figure 10A**

**Figure 10B**

**Figure 10C**

**Figure 10D**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2015333797 A1
- US 2017063165 A1

- US 37188719